# EUROPEAN PATENT APPLICATION

(11) **EP 1 906 254 A1**
(43) Date of publication of application: **02.04.2008**
(21) Application number: 06020704.0
(22) Date of filing: 02.10.2006
(51) Int. Cl.: G03F 7/20

(54) **Methods and systems for water uptake control by resist layers**

(30) Priority: 27.09.2006 GB 0619042
(71) Applicant: Interuniversitair Microelektronica Centrum, 3001 Leuven (BE); Intel Corporation (INTEL), Santa Clara, CA 95052-8119 (US); Tokyo Electron Limited (TEL), Tokyo 107-8481 (JP)
(72) Inventor: Kocsis, Michael, Santa Clara, CA 95054 (US); Foubert, Philippe, 3320 Hoegaarden (BE); Gronheid, Roel, 3370 Boutersem (BE); Nafus, Kathleen, Minato-ku, 107-8481 Tokyo (JP)
(74) Representative: Bird, Ariane

(57) **Abstract**

A method is described for immersion lithographic processing of a device. A substrate with a resist layer is obtained and the resist layer is contacted with immersion liquid, e.g. using an immersion hood, and illuminated through the immersion liquid according to a predetermined pattern to be obtained. The method comprises stimulating immersion liquid uptake by the resist layer for the immersion liquid in contact with the resist layer. The present invention also relates to a resist material for depositing a resist layer allowing such a stimulated immersion liquid uptake.

## Description

### Technical field of the invention

The present invention relates to the field of lithographic processing of devices, e.g. in semiconductor processing. More particularly, the present invention relates to systems and methods for immersion lithographic processing.

### Background of the invention

In the production of today's integrated circuits, optical lithography is one of the key techniques. The ongoing miniaturisation of integrated circuits or other devices results in a number of problems, which may be encountered during optical lithography. When, in an optical lithographic system, light generated by a light source is incident on a mask, the light will be diffracted. The smaller the dimensions of the structures on this mask, the more the light will spread. Hence, the smaller the dimensions of the structures on the mask, the less of this spread-out light will be collected by an objective lens so as to be focused onto a resist layer. As a result, the image of the mask structure formed onto the resist layer will be of a low quality. A well-known solution to cope with the light spreading and consequently to obtain sufficient quality of the mask image is the use of systems having a high numerical aperture (NA). Typically immersion fluids are used to deal with the corresponding incidence of light having a high angle of incidence onto the wafer.

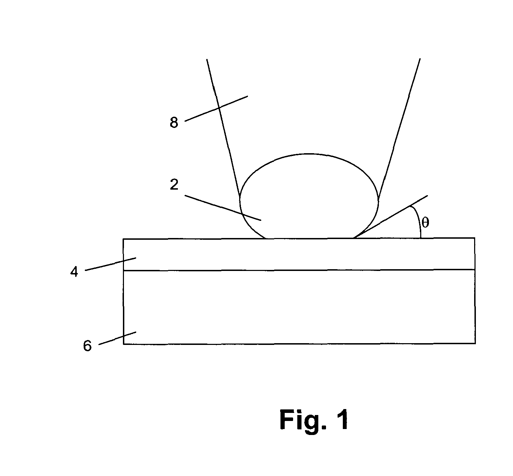

Implementing immersion lithography has given rise to a number of particular problems, for example associated with the use of an immersion fluid in contact with the resist layer used in the lithographic process. One of the problems arising is the presence of watermark defects on the lithographic processed devices. Watermark defects occur when water droplets, e.g. released by the nozzle of an immersion hood, remain on the device to be processed, dry on the surface and leave a residue of dissolved components. Water drops may be left on the surface e.g. when the receding contact angle between the immersion fluid and the substrate surface is too small. The receding contact angle θ between the immersion fluid 2 and the resist or resist stack 4 on the substrate 6 is shown in Fig. 1. Furthermore, the immersion hood 8 also is illustrated. Typically, such defects can affect the development process, resulting in bridging or T-topping defects occurring in circular patterns. Watermark defects typically have a diameter in the range of 1 µm to 5 µm, thus resulting in a high defect ratio. The occurrence of a watermark defect therefore may result in a non-useful die on the substrate.

One known technique for reducing or preventing watermark defects is the increase of the receding contact angle between the immersion hood and the resist. The receding contact angle can be altered e.g. by adjusting the hydrophobic character of the surface of the resist or top layer thereon, by adjusting the scanning speed, the type of showerhead, etc. Illustrations thereof are described e.g. Streefkerk B. et al., Proceedings of SPIE 6154 (2006) and in Kocsis M. et al., Proceedings of SPIE 6154 (2006). An alternative method for reducing or preventing watermarks is described by Kusumoto S. et al. in Polym. Adv. Technol. 17 (2006) 122. The document describes the use of topcoats that are not porous to water. The effect of rinsing on watermark defects also has been studied. The above solutions introduce limitations for the resist or resist stacks used, e.g. with respect to their wettability, and/or to the lithographic system used, e.g. with respect to the shape and scanning speed of the immersion hood.

### Summary of the invention

It is an object of the present invention to provide good methods and systems for lithographic processing of devices as well as products and use thereof for improving lithographic processing of devices. It is an advantage of embodiments according to the present invention that defectivity of lithographic devices obtained by immersion lithographic processing can be reduced.

The above objective is accomplished by a method and device according to the present invention.

The present invention relates to a method for lithographic processing of a device, the method comprising obtaining a substrate with a resist layer, contacting the resist layer with immersion liquid and illuminating the resist layer through the immersion liquid according to a predetermined pattern to be obtained, whereby said method comprises stimulating immersion liquid uptake by the resist layer for the immersion liquid in contact with the resist layer.

It is an advantage of embodiments of the present invention that lithographic processing with a higher device yield is obtained. It is an advantage of embodiments of the present invention that lithographic processing resulting in devices with less defectivity is obtained.

Stimulating the immersion liquid uptake by the resist layer may comprise selecting a resist layer with at least one of a tuned photo-acid generator loading, a tuned quencher concentration.

It is an advantage of embodiments of the present invention that improved device quality can be obtained without the need for significantly altering conventional lithographic systems to be used for immersion lithography.

Stimulating the immersion liquid uptake by the resist layer may comprise selecting a resist layer with at least one of an increased photo-acid generator concentration or an increased quencher loading.

It is an advantage of embodiments of the present invention that an optimum between defectivity reduction and optimum quality of print can be obtained.

Stimulating immersion liquid uptake may comprise adjusting at least one resist application parameter. It is an advantage of such embodiments that defectivity reduction can be reduced by influencing the resist application process, resulting in a large flexibility for the irradiation and configuration of the immersion lithographic process.

Changing at least one resist application parameter may comprise adjusting at least a soft bake temperature, a soft bake time, a soft bake condition, a viscosity of the resist, a solvent of the resist, a spin speed of the resist, a resist temperature, a cup temperature, a humidity during application or a delay time after soft bake.

Stimulating the immersion liquid uptake by the resist layer may comprise selecting a resist layer with at least one of an increased polymer base resin porosity and/or polymer base resin hydrophilicity. The density may be larger than 1.1g/cm³.

Stimulating the immersion liquid uptake by the resist layer may comprise selecting a resist layer with at least one of a tuned polymer base resin porosity and/or polymer base resin hydrophilicity.

Stimulating the immersion liquid uptake may comprise increasing the immersion liquid uptake above 2.7%.

The method furthermore may comprise rinsing the surface of the substrate, e.g. of the resist or resist stack. It is an advantage of embodiments according to the present invention that the effectiveness of a rinsing step in the lithographic processing of the device can be substantially increased by adjusting, i.e. increasing, the water uptake.

The present invention also relates to a resist material for use in immersion lithographic processing of a device, the resist material adapted for stimulating immersion liquid uptake for immersion liquid in contact during immersion lithographic processing with a resist layer consisting of said resist material.

The resist material may comprise at least one of a tuned photo-acid generator concentration and a tuned quencher concentration.

The resist material may comprise at least one of a tuned polymer base resin porosity or a tuned polymer base resin hydrophilicity.

The resist material may comprise at least one of an increased photo-acid generator concentration or an increased quencher concentration.

The resist material may comprise at least one of an increased polymer base resin porosity or an increased polymer base resin hydrophilicity.

The present invention also relates to the use of a resist material as described above in immersion lithographic processing for stimulating immersion liquid uptake by a resist layer consisting of the resist material.

The present invention furthermore relates to a set of resist materials for use in lithographic processing of a device, each of the resist materials being a resist material adapted for stimulating immersion liquid uptake. At least one resist material may be as described above.

The present invention also relates to the use of a set of resist materials as described above in immersion lithographic processing for stimulating immersion liquid uptake by a resist layer made of a selected resist material from said set of resist materials.

The present invention also relates to a method for setting up lithographic processing of a device, the method comprising stimulating immersion liquid uptake for immersion liquid in contact during immersion lithographic processing with a resist layer consisting of said resist material.

Stimulating immersion liquid uptake may comprise selecting a resist material with at least one of a tuned photo-acid generator loading, a tuned quencher concentration, a tuned polymer base resin porosity or a tuned polymer base resin hydrophilicity for said obtained resist layer.

Stimulating immersion liquid uptake may comprise selecting a resist material with at least one of an increased photo-acid generator concentration, an increased quencher concentration, an increased polymer base resin porosity or an increased polymer base resin hydrophilicity.

Stimulating immersion liquid uptake may comprise adjusting at least one resist application parameter of a resist application process.

Changing at least one resist application parameter may comprise adjusting at least a soft bake temperature, a soft bake time, a soft bake condiction, a viscosity of the resist, a solvent of the resist, a spin speed of the resist, a resist temperature, a cup temperature, a humidity during application or a delay time after soft bake.

The present invention also relates to a method for lithographic processing of a device, wherein stimulating immersion liquid uptake is performed for increasing the effectiveness of a rinsing step in the lithographic processing of the device as mitigation strategy.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The teachings of the present invention permit the design of improved lithographic methods and systems allowing lithographic processing of devices, e.g. electronic devices with a higher yield.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a schematic illustration of an immersion hood allowing immersion lithographic processing of a device, as known from prior art.
Fig. 2 is a schematic representation of an immersion lithographic system as can be used in embodiments according to the present invention.
Fig. 3 is a schematic representation of part of a lithographic set-up according to an embodiment of the present invention.
Fig. 4 is an image of a watermark defect as can be influenced by influencing immersion liquid uptakeaccording to embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments. Various features may be grouped in a single embodiment, figure or description. However, is not to be interpreted as reflecting an intention that the claimed invention requires more features than are expressly recited in each claim. The claims following the detailed description are hereby expressly incorporated into this detailed description, with each claim standing on its own as a separate embodiment of this invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention. In embodiments of the present application, the term "substrate" may include not only the basic carrier material but also materials to be processed and typical materials applied for performing a lithographic processing step, such as for example - but not limited to - a bottom anti-reflective coating. The term "substrate" furthermore also may include other materials, such as e.g. other materials used in semiconductor processing. The basic carrier material may be for example doped or undoped silicon, silicon-on-insulator substrate (SOI), gallium arsenide (GaAs), gallium arsenide phosphide (GaAsP), indium phosphide (InP), germanium (Ge), or silicon germanium (SiGe), glass or quartz substrates.

Where in the present application reference is made to "light" or "radiation", electromagnetic radiation typically used in immersion lithographic systems is referred to. In present application, often electromagnetic radiation having a wavelength of 193nm is used, but the invention is not limited thereto and other wavelengths in the ultraviolet and/or deep ultraviolet range or even other types of electromagnetic radiation may be used.

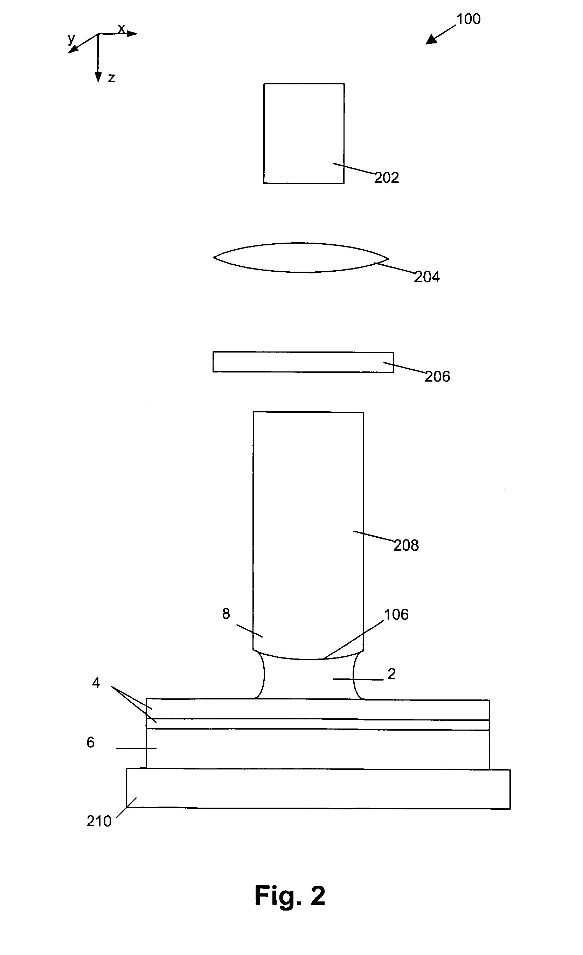

The embodiments of the present invention typically may be related to an immersion lithographic processing system. The method is applicable to lithographic processing which can be performed on any type of immersion lithographic set-up, such as but not limited to the set-up shown in Fig. 2, shown by way of illustration only. An optical lithographic system with a transmission set-up is shown, although the invention is not limited thereto and is e.g. also applicable to a system with a reflection set-up. It may be e.g. an immersion lithographic stepper system or an immersion lithographic scanner system. The optical immersion lithographic system 100 typically comprises a source of electromagnetic radiation, e.g. an irradiation source 202. The radiation from the irradiation source 202 typically is transmitted through an optical system 204 comprising a lens and is incident on a mask 206. The mask 206 contains information about the image to be generated in a resist layer or resist stack 4 and is basically defined thereby. Typically the mask 206 may be part of a set of masks used for creating a device or circuit using lithography. Different types of masks exist; such as e.g. an alternated phase shift mask, an attenuated phase shift mask, a binary mask, etc. The light, carrying the mask information, is then passed through an imaging module 208, which e.g. may have a final lens surface 106, and thus is guided to a resist layer or resist stack 4 on a substrate 6. The optics of the imaging module 208 inherently defines the numerical aperture (N.A.) of the imaging module 208. The device 102 typically is mounted on a substrate stage 210. Typically an immersion showerhead 8, also referred to as immersion hood 8, provides an immersion liquid 2 between the resist layer or resist stack 4 and the output of the imaging module 208, e.g. the final lens surface 106, in order to allow increase of the numerical aperture of the system 100. Other optional and/or additional components are not illustrated in Fig. 2. The present invention will now further be described with respect to a number of different aspects and embodiments, the invention not being limited thereto.

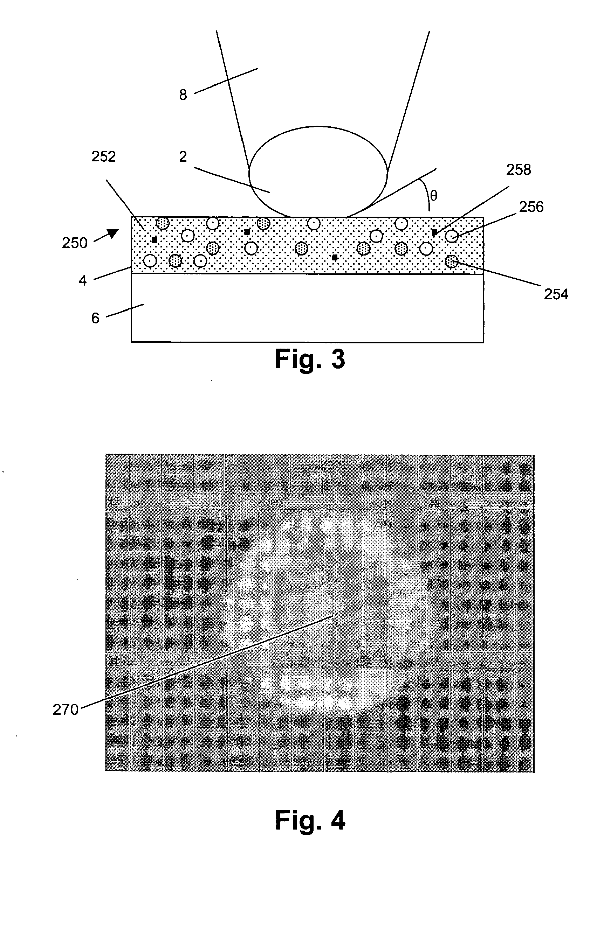

In a first aspect, the present invention relates to a method for lithographic processing of a device. The method for lithographic processing comprises stimulating the uptake of immersion liquid by the resist layer. The latter allows to reduce watermark defectivity. Reduction of watermark defectivity thereby may be both reduction of the number of watermark defects present on a lithographic processed device as well as reduction of the intensity of the watermark defect(s) or of the size of the watermark defect. The relative intensity of watermark defects may for example be determined by the total area of pattern damage by the watermark for various materials or process conditions when a water droplet of a fixed volume is deposited. The presence of watermark defects on a device is determined both by the presence of immersion liquid drops left behind on the device surface during lithographic processing and the interaction with the underlying resist layer. The present invention is concerned with the interaction between immersion liquid drops left on the device surface and the underlying resist layer. The immersion liquid drop(s) thereby are in contact with the resist layer, either directly or indirectly. For example, a top coating may be provided on the resist layer and immersion liquid may be provided on the top coating during immersion lithographic processing. An illustration of part of a lithographic processing set up is shown in Fig. 3, illustrating part of the immersion hood 8, a substrate 6 with a resist layer 4 and immersion liquid 2. The present invention reduces watermark defectivity by stimulating immersion liquid 2 uptake by the resist layer 4 for the immersion liquid 2 in contact, direct or indirect, with the resist layer 4. The method therefore comprises obtaining a substrate 6 with a resist layer 4 and contacting the resist layer 4 with immersion liquid 2 and illuminating the resist layer 4 through the immersion liquid 2 according to a predetermined pattern to be obtained. The substrate 6 obtained may be any suitable substrate as described above, such as e.g. a semiconductor substrate. The resist layer 4 may be previously provided on the substrate 6, or the lithographic processing method may comprise providing the resist layer 4 on the substrate 6. The resist layer 4 may be made of resist material 250 that is positive resist material or negative resist material. It may be a chemically amplified resist material. It may be an immersion lithographic specific resist material. The resist material 250 preferably comprises a polymer base resin 252, a photo-acid generator (PAG) 254, a quencher 256 and a photoresist solvent 258, as indicated in Fig. 3. Typical examples of resist materials that may be used, without limiting the invention thereto, are PAR-817 resist and PAR-IM850 resist as available from Sumitomo Inc. The polymer base resin 252 is the component remaining on the substrate 6 after developing of the resist material 250. Typical examples of polymer base resins 252 that may be used in resist materials 250 may be for example ARF methacrate type polymer which have protect group and lactone group. The photo-acid generator component 254 provides acid component in the resist material 250 once the resist material 250 is irradiated. This component converts the molecular structure of the polymer base resin 252, resulting in either a more easy or a more hard polymer structure to be removed during developing and etching. The quencher 256 provides the functionality of controlling the diffusion length of the acid generated by a photo-acid generator. The photoresist solvent 258 allows to control the viscosity of the photoresist material. The method for lithographic processing according to the present invention furthermore comprises stimulating immersion liquid uptake by the resist layer for the immersion liquid in contact with the resist layer. Stimulating the immersion liquid uptake can be performed in a number of ways, e.g. by selecting an appropriate resist material wherein a high water uptake occurs. When water uptake is e.g. quantified as the volume of water absorbed by unit volume of the film, expressed in percents, at saturation. The average water uptake may be within a range 1.5% and 2.3%, or a range 1.5% and 2.7%, on average e.g. being 2%. High water uptake thus may be obtained when the water uptake is higher than 2.3%, preferably higher than 2.5%, more preferably higher than 2.7%. Stimulating immersion liquid uptake by the resist layer therefore may comprise selecting a resist layer with tuned properties. Such tuned properties may e.g. be a tuned photo-acid generator loading, a tuned quencher loading, a tuned polymer base resin porosity or a tuned polymer base resin hydrophillicity. In a preferred example, the tuned properties may be at least one of an increased photo-acid generator concentration, an increased quencher concentration, an increased polymer base resin porosity and/or an increased polymer base resin hydrophilicity. In a preferred embodiment, the different properties may be different photo-acid generator components 254 or different photo-acid generator component concentrations and/or different quencher concentrations 256. Typically the concentrations, density or hydrophilicity may be increased with respect to concentrations, density or hydrophilicity present in conventionally used resist layers, e.g. resist layers optimised for e.g. process window obtained for the lithographic processing, and/or for other parameters being any of or a combination of MEEF, line-edge roughness, resolution, etc. MEEF thereby is the mask error enhancement factor. With MEEF is meant the incremental change in the final resist feature size per unit change in the corresponding mask feature size, where the mask dimension is scaled to wafer size by the reduction ratio of the imaging tool. The degree of water uptake therefore adds an additional constraint to the resist design. Alternatively or in addition thereto, the properties of the resist layer also could be tuned by tuning process parameters for the application process of the resist material on the substrate. The latter may include e.g. at least one of a viscosity of the resist, a solvent of the resist, a spin speed for applying the resist if spinning is used, a resist temperature, a cup temperature, a humidy during application, and/or a soft bake parameter, such as for example a soft bake temperature, a soft bake time a soft bake condition, a delay time after soft bake. In one embodiment, obtaining a substrate with a resist layer comprises selecting a resist material from a number of predetermined resist materials, each of them having different resist properties for stimulating immersion liquid uptake, such as e.g. a different photo-acid generator component or a different concentration thereof, a different quencher concentration, a different polymer base resin density or a different polymer base resin hydrophilicity. Such a selection also may be a selection from a set of resist materials 250 that may be used, each having their predetermined resist properties being different from each other. Such a selection could e.g. be made as function of the particular lithographic settings for lithographic processing, i.e. for the resolution, i.e. the critical dimension, to be obtained or for the irradiation dose to be used. Such particular lithographic settings may be settings which are application specific, i.e. these may dependent e.g. on the pattern to be generated.

Selecting also may comprise a simulation step or computing step for determining the allowable resist adjustment as function of other lithographic processing parameters to be obtained. The latter may be done in an automated and/or automatic way. It may be performed according to a predetermined algorithm, based on trial and error, using a neural network, using reference simulation results or measurement results previously obtained or obtained at that moment, etc. Selection of a resist with predetermined immersion liquid uptake behaviour, optionally in combination with other lithographic processing requirements, may be performed with respect to a predetermined rule or requirement, e.g. the number of resulting watermarks being lower than a predetermined value, the average diameter of the watermarks being lower than a predetermined value, etc. Selecting the resist to be used may comprise selecting a resist material from a set of resist materials, the selected resist material having resist properties being closest to the resist properties preferred in order to reduce sensitivity to watermark defects. The resist may be obtained by mixing the different components.

The method furthermore comprises irradiating the resist layer according to a predetermined pattern. Other optional steps for the lithographic processing may include baking steps, developing steps, etching steps, cleaning steps, etc. and are known in the art. In an example, stimulating water uptake also may be obtained by controlling processing conditions preceding the application of the immersion liquid.

A number of parameters of the lithographic processing system or application are system and application specific and/or may be selected as function of their availability or their influence on the print to be obtained. By way of example, the present invention not being limited thereby, a set of possible parameters may be as follows :

The substrate used may be a bare silicon substrate (12inch) provided with an anti-reflective coating ARC29A as available from Brewer science. The resist film thickness may be 150nm. The resist film may be applied using a Tokyo-electron, CLEAN TRAC ACT12 system. The exposure tool is a ASML XT1250i lithographic system, with an illumination system with parameters NA=0.85, Annular(0.89/0.57). The reticle used is a binary reticle with 100nmL/S pattern to look for defectivity. The developer used is TMAH2.38wt%(23°C, 60sec) as available from LFCS Ltd. The critical dimension obtainable is characterised by Hitachi 9380ll by Hitachi-high technology. The pattern size used is a 100nmL/200nmP top-down pattern. A stack of bare silicon, a bottom anti-reflective coating and a resist layer may be used wherein the bottom anti-reflective coating is applied under 205°C during 90s, the resist coating has occurred with a soft bake of 120°C during 60s. The tool used for checking the defectivity is a KLA2351 defectivity tool.

By way of illustration, the method will be further illustrated by way of particular embodiments, the invention not being limited thereto. Reduction of immersion liquid uptake may result in a reduction of watermark defectivity in the resulting lithographic processed devices. A typical watermark defect is shown in Fig. 4.

In a first particular embodiment, the method relates to a method for lithographic processing as described above, wherein stimulating immersion liquid uptake by the resist layer comprises selecting a resist layer for providing it on the substrate to be obtained with a tuned photo-acid generator component. The tuned photo-acid generator component may e.g. be tuned with respect to the chemical composition, in other words different types of photo-acid generator components may be selected, or may e.g. be tuned with respect to the concentration. Different types of photo-acid generator components that may be selected are for example Triphenylsulfonium nonafluoro-n-butanesulfonate TPST, Triphenylsulfonium trifluoromethanesulfonate TPSN, Triphenylsulfonium per-fluoro-n-octanesulfonate TPSO. The tuning may be performed with reference to the effect on immersion liquid uptake. In a preferred example, the concentration of the photo acid generator may be increased with respect to a standard concentration of photo-acid generator component 254. Such a standard concentration may be different for different standard resist materials. It may e.g. be determined based on the maximum obtainable process window, possibly combined with other parameters. According to the present embodiment, the photo-acid concentration is selected higher than such standard concentration. The photo-acid generator component concentration may for example be larger than 2 weight percent, e.g. larger than 3 weight percent or for example be larger than 5 weight percent, or larger than 7 weight percent, or larger than 10 weight percent. In principle the larger the photo-acid generator component, the better. The maximum concentration for the photo-acid generator may be 20 weight percent or 15 weight percent.

In a second particular embodiment, the method relates to a method for lithographic processing as described above, wherein stimulating immersion liquid uptake by the resist layer comprises selecting a resist layer for providing it on the substrate to be obtained, whereby the resist layer has a tuned quencher concentration. So selecting a resist layer with a tuned quencher concentration or tuning the quencher concentration may be tuning such that the immersion liquid uptake is stimulated. In the present embodiment, tuning the quencher component 256 concentration may depend on the other components present in the resist 250. Tuning the quencher component 256 may for example comprise increasing the quencher component 256 concentration with respect to a standard concentration of quencher component 256 present in the resist material. Often such a standard concentration may be in the range 0.25 to 1.5 weight percent per polymer.

In a third particular embodiment, the method relates to a method for lithographic processing as described above, wherein stimulating immersion liquid uptake by the resist layer comprises selecting a resist layer for providing it on the substrate to be obtained, whereby the selected resist layer has a tuned polymer base resin density. In a preferred example, the density is tuned such that the porosity of the resist layer is increased. Increasing the polymer base resin density may be selecting a polymer base resin density larger than that of the standard polymer base resin used, i.e. for example larger than the density of methacrylate polymers (for ArF-type resists) which have protect groups and lactone groups. Increasing the polymer base resin density may be selecting a polymer base resin density larger than 1.1 g/cm3.

In a fourth particular embodiment, the method relates to a method for lithographic processing as described above, wherein stimulating immersion liquid uptake by the resist layer comprises selecting a resist layer for providing it on the substrate to be obtained, whereby the selected resist layer has a tuned polymer base resin hydrophilicity. Hydrophilicity thereby expresses the degree or amount of hydrophilic behaviour occurring. A high hydrophilicity or high degree of hydrophilicity expresses that a material has large hydrophilic properties. In a preferred embodiment according to the present embodiment the resist layer 4 or corresponding resist material 250 is selected to comprise a polymer base resin with a high hydrophilicity. The polymer base resin thus has a thermodynamically favourable interaction with water. In the present case, the later results in an increased water uptake. The resist material 250 may be selected to comprise a polymer base resin with a high hydrophilicity, i.e. than a resist material with a log P of 2.5.

In a fifth particular embodiment, the method relates to a method for lithographic processing as described above, wherein stimulating immersion liquid uptake by the resist layer comprises providing a resist layer on the substrate according to a resist providing process wherein at least one resist providing process parameter is tuned. Such a resist providing process may comprise the steps of applying resist material to a substrate, e.g. by spin coating or dip coating, applying a soft bake to the resist layer formed, etc. Resist providing process parameters may for example be a soft bake parameter such as a soft bake temperature, a soft bake time, a soft bake condition or a delay time after soft bake, a spin speed of the resist if spinned on the substrate, a resist temperature, a cup temperature, i.e. the environment temperature during coating of the resist, a degree of humidity during application, a viscosity of the resist, a solvent of the resist. These parameters may be tuned in order to increase the immersion liquid uptake. In the resulting lithographic process, the amount of immersion liquid taken up by the resist layer when in contact with the resist layer will be larger, resulting in a smaller sensitivity for watermark defect formation.

In a sixth particular embodiment, a method for lithographic processing of a device as described above is disclosed, wherein stimulating immersion liquid uptake is performed for increasing the effectiveness of a rinsing step in the lithographic processing of the device as mitigation strategy. It has surprisingly been found that stimulating the immersion liquid uptake significantly increases the effectiveness of the rinsing step. As a rinsing step may result in a significant reduction of watermark defects, the latter can advantageously be applied. Stimulating of the immersion liquid uptake may be performed in any suitable way, e.g. by adjusting the resist material 250 and/or resist layer 4 or the application thereof on the device, as described above, e.g. in any of the above embodiments. The method for lithographic processing therefore also may comprise a pre-exposure rinsing step or a post-exposure rinsing step, respectively performed before and after exposure of the resist. The effectiveness of such a rinsing step thereby is influenced, i.e. increased by stimulating the immersion liquid uptake.

In a second aspect, the present invention relates to a resist material 250 for use in lithographic processing, for example as described in the first aspect, wherein the resist properties of the resist material 250 are tuned as to stimulate the immersion liquid uptake when immersion liquid drops are in contact with a resist layer of the resist material 250. In a preferred embodiment, the resist properties of the resist material 250 thus are selected in order to increase the immersion liquid uptake. With stimulated immersion liquid uptake there is meant that the resist layer is able to absorb. The water thereby may be absorbed in the pores of the polymer structure, e.g. film, and may cause swelling of the film. With increased immersion liquid uptake there is meant that more immersion liquid is taken up by the resist layer as compared to conventional resist layers, as used for conventional lithography. The average water uptake may be within a range 1.5% and 2.3%, or a range 1.5% and 2.7%, on average e.g. being 2%. High water uptake thus may be obtained when the water uptake is higher than 2.3%, preferably higher than 2.5%, more preferably higher than 2.7%. The resist material may comprise a tuned photo-acid generator component 254 and/or a tuned quencher component 256 and/or a tuned density or porosity of the polymer base resin and/or a tuned degree of hydrophilicity of the polymer base resin. The tuning may be selection of a concentration of the photo-acid generator 254 and/or selection of the quencher component 256 concentration and/or selection of the porosity or density of the polymer base resin and/or selection of the degree of hydrophilicity of the polymer base resin. In a preferred embodiment, tuning may be increasing the photo-acid generator 254 concentration, the quencher component 256 concentration, the porosity of the polymer base resin and/or the degree of hydrophilicity of the polymer base resin, e.g. increasing at least one of those above the standard concentration. Such a standard concentration may be a concentration determined based on the optimal process window obtainable with the immersion lithographic process used or a concentration determined based on a combination of the optimal process window and other parameters being any of or a combination of MEEF, line-edge roughness, resolution, etc.

The ranges within which these parameters may be varied are the same as described in the different particular embodiments of the first aspect. In a preferred embodiment, the different properties of the resist may be different photo-acid generator components 254 or different photo-acid generator component concentrations and/or different quencher concentrations 256. Other features and advantages of the resist material may also be as described in the first aspect.

In a third aspect, the present invention relates to the use of a resist material 250 as described in the second aspect for immersion lithographic processing as to stimulate water uptake of a resist layer contacted with immersion liquid in immersion lithographic processing. The latter allows to reduce the number, size and or intensity of watermark defects present on devices that are lithographic processed or even may allow to avoid watermark defects. It is an advantage of embodiments using such resist material 250 that no substantial changes need to be made to the lithographic processing system used, i.e. no actual changes are required.

In a fourth aspect, the present invention relates to a set of resist materials 250 for immersion lithographic processing of a device, wherein the resist materials 250 have different resist properties. The different resist properties thereby are properties of the resist material resulting in a different immersion liquid uptake behaviour of a resulting resist layer based on the resist materials. Such different properties may be for example different photo-acid generator components 254 or different photo-acid generator component concentrations and/or different quencher concentrations 256 and/or different polymer base resin density and/or different polymer base resin hydrophilicity in the resist material 250, or more particularly in the resulting resist layers made using the resist material 250. In a preferred embodiment, the different properties may be different photo-acid generator components 254 or different photo-acid generator component concentrations and/or different quencher concentrations 256. A set of resist materials 250 may be used to select an appropriate resist material 250 depending on the allowed immersion liquid uptake, the watermark sensitivity and/or depending on other requirements for the lithographic processing of the device. Selection of a resist material with predetermined properties may e.g. also be performed based on the critical dimension to be obtained, the allowed and usable exposure dose, the exposure time, the process window, the MEEF, the line edge roughness, etc. Such a set of resist materials may be a set of resist materials, each resist material being as described in the second aspect, wherein other parameters of the lithographic process to be applied, e.g. relating to exposure parameters that may be pattern specific, are taken into account. The set of resist materials 250 preferably comprises a plurality of resist materials 250, labelled as to indicate lithographic processing conditions that can be obtained using the resist materials 250.

In a fifth aspect, the present invention relates to the use of such a set of resist materials 250 in lithographic processing of a device. Lithographic processing of a device thereby may comprise selecting one of resist material from the set of resist materials. Such a selection may be based on the required immersion liquid uptake. The latter may be indirectly determined based on the required degree of sensitivity or insensitivity to watermark defects. Furthermore, e.g. in combination with immersion liquid uptake, selection of one resist material may be based on required lithographic processing goals or parameters, such as the critical dimension required, dose, the exposure time, the process window, the MEEF, the line edge roughness, etc for the particular application.

It is to be understood that although preferred embodiments, specific constructions and configurations, as well as materials, have been discussed herein for devices according to the present invention, various changes or modifications in form and detail may be made without departing from the scope and spirit of this invention. For example, whereas the invention has been described by way of a (set of) resist(s), use thereof and a method for lithographic processing, the present invention also relates to a method for setting up lithographic processing, wherein the method comprises tuning a resist material by tuning a photo-acid generator component and/or a quencher component and/or polymer base resin density or hydrophilicity for stimulating immersion liquid uptake of a resist layer during lithographic processing, thus obtaining a tuned resist material. The tuning may be performed as described in the previous aspects of the present invention.

## Claims

1. A method for lithographic processing of a device, the method comprising
- obtaining a substrate with a resist layer
- contacting the resist layer with immersion liquid and illuminating the resist layer through the immersion liquid according to a predetermined pattern to be obtained,
whereby said method comprises
- stimulating immersion liquid uptake by the resist layer for the immersion liquid in contact with the resist layer.

2. - A method according to claim 1, wherein stimulating the immersion liquid uptake by the resist layer comprises selecting a resist layer with at least one of a tuned photo-acid generator loading, a tuned quencher concentration.

3. - A method according to any of claims 1 to 2, wherein stimulating the immersion liquid uptake by the resist layer comprises selecting a resist layer with at least one of an increased photo-acid generator concentration or an increased quencher loading.

4. - A method according to any of claims 1 to 3, wherein stimulating immersion liquid uptake comprises adjusting at least one resist application parameter.

5. - A method according to claim 4, wherein changing at least one resist application parameter comprises adjusting at least a soft bake temperature, a soft bake time, a soft bake condition, a viscosity of the resist, a solvent of the resist, a spin speed of the resist, a resist temperature, a cup temperature, a humidity during application or a delay time after soft bake.

6. - A method according to any of claims 1 to 5, wherein stimulating the immersion liquid uptake by the resist layer comprises selecting a resist layer with at least one of an increased polymer base resin porosity and/or polymer base resin hydrophilicity.

7. - A resist material (250) for use in immersion lithographic processing of a device, the resist material (250) adapted for stimulating immersion liquid uptake for immersion liquid in contact during immersion lithographic processing with a resist layer consisting of said resist material (250).

8. - A resist material (250) according to claim 7, wherein the resist material (250) comprises at least one of a tuned photo-acid generator concentration and a tuned quencher concentration.

9. - A resist material (250) according to any of claims 7 to 8, wherein the resist material (250) comprises at least one of an increased photo-acid generator concentration or an increased quencher concentration.

10. -Use of a resist material (250) according to any of claims 7 to 9 in immersion lithographic processing for stimulating immersion liquid uptake by a resist layer consisting of the resist material (250).

11. -A set of resist materials (250) for use in lithographic processing of a device, each of the resist materials (250) being a resist material (250) adapted for stimulating immersion liquid uptake.

12. -A set of resist materials according to claim 11, at least one resist material (250) being according to any of claims 7 to 9.

13. - Use of a set of resist materials (250) according to any of claims 11 to 13 in immersion lithographic processing for stimulating immersion liquid uptake by a resist layer made of a selected resist material from said set of resist materials.

14. - A method for setting up lithographic processing of a device, the method comprising stimulating immersion liquid uptake for immersion liquid in contact during immersion lithographic processing with a resist layer consisting of said resist material (250).

15. - A method for setting up lithographic processing according to claim 14, wherein stimulating immersion liquid uptake comprises selecting a resist material with at least one of a tuned photo-acid generator loading, a tuned quencher concentration, a tuned polymer base resin porosity or a tuned polymer base resin hydrophilicity for said obtained resist layer.

16. - A method for setting up lithographic processing according to any of claims 14 to 15, wherein stimulating immersion liquid uptake comprises selecting a resist material with at least one of an increased photo-acid generator concentration, an increased quencher concentration, an increased polymer base resin porosity or an increased polymer base resin hydrophilicity.

17. - A method for setting up lithographic processing according to any of claims 14 to 16, wherein stimulating immersion liquid uptake comprises adjusting at least one resist application parameter of a resist application process.

18. -A method for setting up lithographic processing according to claim 17, wherein changing at least one resist application parameter comprises adjusting at least a soft bake temperature, a soft bake time, a soft bake condition, a viscosity of the resist, a solvent of the resist, a spin speed of the resist, a resist temperature, a cup temperature, a humidity during application or a delay time after soft bake.
